# EUROPEAN PATENT APPLICATION

(11) **EP 4 539 622 A1**
(43) Date of publication of application: **16.04.2025**
(21) Application number: 24206148.9
(22) Date of filing: 11.10.2024
(51) Int. Cl.: H05K 7/14

(54) **EQUIPMENT RACK ARRANGEMENTS AND METHODS OF INSTALLING EQUIPMENT RACKS**

(30) Priority: 13.10.2023 US 202363543981 P; 10.10.2024 US 202418911737
(71) Applicant: Schneider Electric IT Corporation, Foxboro, MA 02035 (US)
(72) Inventor: SHEEHAN, Stuart Michael, Massachusetts, 01810 (US); SCHOUTEN, Robert Brian, Foxboro, 02035 (US)
(74) Representative: Plasseraud IP

(57) **Abstract**

An equipment rack arrangement includes a first row of equipment racks and at least one horizontal busbar extending horizontally through the equipment racks of the first row of equipment racks. The at least one horizontal busbar is configured to provide power to electronic equipment supported by the equipment racks of the first row of equipment racks. The equipment rack arrangement further may include at least one vertical busbar extending vertically through equipment racks of the first row of equipment racks.

## Description

### BACKGROUND OF THE DISCLOSURE

### Field of Disclosure

The present disclosure relates to the physical arrangement of components including equipment racks within a data center. The arrangement is facilitated by liquid cooling electrical components with equipment racks.

### Discussion of Related Art

Specifically, embodiments of the present disclosure enable a person arranging equipment racks in the data center to decrease or eliminate the space taken for a hot aisle between two rows of equipment racks and to better distribute high power amongst IT equipment racks via direct connection to common horizontal busbars. Further, embodiments of the present disclosure enable fans to be removed from servers thereby enabling smaller servers.

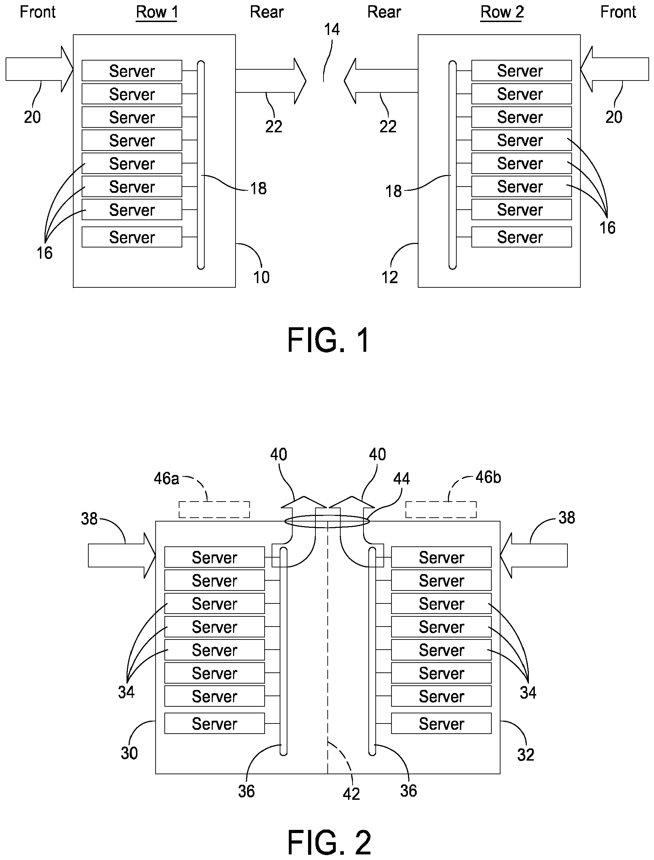

FIG. 1 illustrates a first row of equipment racks, together indicated at 10, and a second row of equipment racks, together indicated at 12, with the second row of equipment racks being spaced from the first row of equipment racks to create a hot aisle 14. As shown each equipment rack within each row of equipment racks 10, 12 includes several servers, each indicated at 16, with each server being in fluid communication with a liquid cooling system, indicated at 18. With the arrangement shown in FIG. 1, relatively cool air is drawn through the fronts of each row of equipment racks 10, 12 from a "cold aisle" (arrows 20) and exhausted through the backs of each row of equipment racks (arrows 22). Relatively hot air is delivered into the hot aisle 14 where the air is circulated for treatment.

Power distribution consists of either busway overhead (requiring tap-off units and cabling to and from busway) or a power distribution unit (PDU) and/or remote power panels (RPPs) requiring cable connection between distribution panels and each rack.

### BRIEF DESCRIPTION OF THE DRAWINGS

Various aspects of at least one embodiment are discussed below with reference to the accompanying figures, which are not intended to be drawn to scale. The figures are included to provide an illustration and a further understanding of the various aspects and embodiments, and are incorporated in and constitute a part of this specification, but are not intended as a definition of the limits of any particular embodiment. The drawings, together with the remainder of the specification, serve to explain principles and operations of the described and claimed aspects and embodiments. In the figures, each identical or nearly identical component that is illustrated in various figures is represented by a like numeral. For purposes of clarity, not every component may be labeled in every figure. In the figures:
FIG. 1 is an end schematic view of a portion of a data center having two rows of equipment racks separated from one another by a hot aisle;
FIG. 2 is an end schematic view of a portion of a data center with backs of equipment racks of a first row of equipment racks facing and being located proximate to backs of equipment racks of a second row of equipment racks in accordance with an embodiment of the present disclosure;
FIG. 3 is a perspective view of a portion of a data center having two rows of equipment racks positioned next to one another in accordance with an embodiment of the present disclosure;
FIG. 4 is a perspective view of the portion of the data center shown in FIG. 3 showing one row of equipment racks and a horizontal busbar passing through the equipment racks;
FIG. 5 is a schematic view of a row of equipment racks in accordance with an embodiment of the present disclosure;
FIF. 6A is an end view of two rows of equipment racks positioned next to one another showing horizontal busbars used to distribute power within the equipment racks in accordance with an embodiment of the present disclosure;
FIG. 6B is a perspective view of the two rows of equipment racks shown in FIG. 6A; and
FIG. 7 is a schematic end view of two rows of equipment racks positioned next to one another showing airflow through the rows of equipment racks in accordance with an embodiment of the present disclosure.

### DETAILED DESCRIPTION OF THE DISCLOSURE

This disclosure is not limited in its application to the details of construction and the arrangement of components set forth in the following descriptions or illustrated by the drawings. The disclosure is capable of other embodiments and of being practiced or of being carried out in various ways. Also, the phraseology and terminology used herein is for description purposes and should not be regarded as limiting. The use of "including," "comprising," "having," containing," "involving," and variations herein, are meant to be open-ended, i.e., "including but not limited to."

Referring to the drawings, and more particularly to FIG. 2, an IT equipment rack of a first row of IT equipment racks is indicated at 30 and another IT equipment rack of a second row of IT equipment racks is indicated at 32. A standard IT equipment rack may include a 19-, 21- or 23-inch equipment rack having a standardized frame or enclosure to mount electronic equipment. As will be discussed in greater detail below, such equipment racks are used to support electronic equipment, including but not limited to power distribution units (PDUs), uninterruptible power supplies (UPSs), battery modules, cooling modules, and the like. Further, equipment racks can be used to support other types of IT equipment, such as servers, telecommunications and networking equipment and hardware, displays and related equipment, e.g., cooling equipment.

In one embodiment, each IT equipment rack 30, 32 includes a chassis or frame structure that defines an enclosure. The chassis of each IT equipment rack 30, 32 includes an open front having several mounting slots that are each configured to slidably receive electronic equipment, e.g., servers, each indicated at 34. It should be noted that each equipment rack 30, 32 can be configured to accommodate any number of pieces of electronic equipment, with the size of the mounting slots being dependent on the size of the equipment received within the mounting slots. As shown in FIG. 2, each IT equipment rack 30, 32 is configured to support several servers 34, each of which is cooled by a liquid cooling system 36. As shown, each server 34 is connected to the liquid cooling system 36 to provide liquid cooling to the server. In the shown embodiment, in addition to the liquid cooling system 36, relatively cool air from a cold aisle is delivered to fronts of the IT equipment racks 30, 32, as shown by arrows 38, drawn through the servers 34, and directed upwardly towards tops or roofs of the IT equipment racks 30, 32 where the relatively hot air is exhausted from the IT equipment racks 30, 32, as shown by arrows 40.

In some embodiments, in place of two IT equipment racks, e.g., IT equipment racks 30, 32, a single enclosure can be provided with two columns of servers, or two enclosure mounted flush back-to-back with one another.

In some embodiments, an airflow divider, indicated at 42, can be disposed between the backs of the two IT equipment racks 30, 32. The air divider 42 separates air directed to the front of the equipment rack 30 of the first row of equipment rack and the front of the equipment rack 32 of the second row of equipment racks. For each equipment rack 30, 32, the air divider 42 is provided to ensure that the cool air 38 entering through the front of the equipment rack travels upwardly through the equipment rack to the top of the equipment rack and not to the equipment rack in the other row.

In some embodiments, an exhaust fan 44 may be provided to draw relatively cool air from a cold aisle and to exhaust air out of the equipment racks. In one embodiment, the exhaust fan 44 may be provided between the equipment rack 30 of the first row of equipment racks and the equipment rack 32 of the second row of equipment racks. The exhaust fan 44 may be configured to draw or otherwise move air from a front of the equipment rack 30 of the first row of equipment racks and a front of the equipment rack 32 of the second row of equipment racks. The exhaust fan 44 further may be configured to exhaust or otherwise move air through a top of the equipment rack 30 of the first row of equipment racks and through a top of the equipment rack 32 of the second row of equipment racks. The exhaust fan 44 embody a fan module having a fan, with the fan module being coupled to a controller, e.g., controller 82 described below, configured to control the operation of the fan module. In this embodiment, air is configured to be exhausted or removed from the equipment rack 30 of the first row of equipment racks and the equipment rack 32 of the second row of equipment racks and delivered to a return plenum positioned above the equipment racks 30, 32.

In some embodiments, there may be several exhaust fans 44 provided along the lengths of the first and second rows of equipment racks, which are spaced from one another.

In another embodiment, an exhaust fan 46a may be provided at top of the equipment rack 30 of the first row of equipment racks and an exhaust fan 46b may be provided at a top of the equipment rack 32 of the second row of equipment racks. Exhaust fan 46a may be configured to draw or otherwise move air from a front of the equipment rack 30 of the first row of equipment racks and to exhaust or otherwise move air through the top of the equipment rack 30 of the first row of equipment racks. Similarly, exhaust fan 46b may be configured to draw or otherwise move air from a front of the equipment rack 32 of the second row of equipment racks and to exhaust or otherwise move air through the top of the equipment rack 32 of the second row of equipment racks. Each exhaust fan 46a, 46b may be coupled to a controller configured to control the operation of each fan module. In this embodiment, air is configured to be exhausted or removed from each equipment rack 30, 32 and delivered to one or more plenums positioned above the equipment racks 30, 32.

In some embodiments, server-based fans can be provided to push/pull air horizontally through the servers in each equipment rack and to exhaust air through the center/top of the equipment rack.

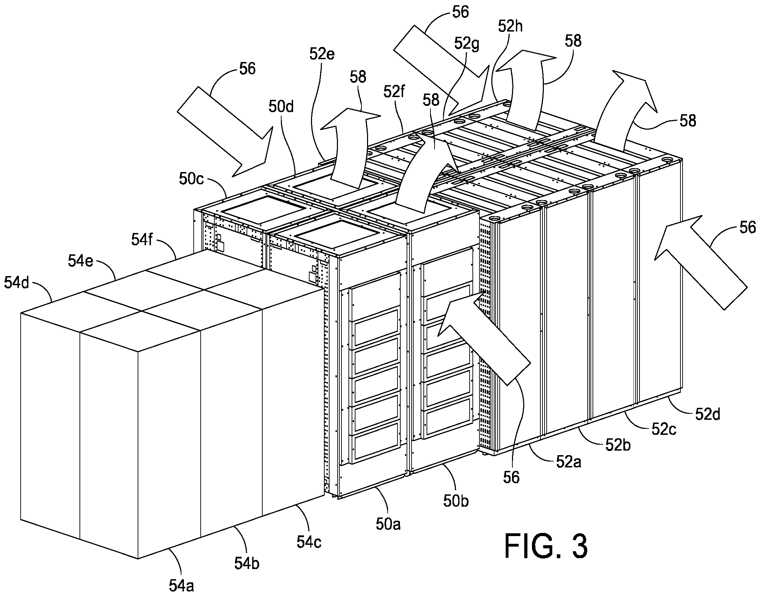

Referring to FIG. 3, an example configuration includes two rows of equipment racks. Specifically, the example configuration includes four power converter cabinets, indicated at 50a, 50b, 50c, 50d, eight IT equipment racks, indicated at 52a, 52b, 52c, 52d, 52e, 52f, 52g, 52h, and six generic racks, indicated at 54a, 54b, 54c, 54d, 54e, 54f. The first row of equipment racks includes power converter cabinets 50a, 50b, IT equipment racks 52a, 52b, 52c, 52d, and generic racks 54a, 54b, 54c. The second row of equipment racks includes power converter cabinets 50c, 50d, IT equipment racks 52e, 52f, 52g, 52h, and generic racks 54d, 54e, 54f.

The power converter cabinets 50a, 50b, 50c, 50d, each can be configured to include power equipment including integrated alternating current (AC) to direct current (DC) converters or DC to DC converters. The power converter cabinets 50a, 50b, 50c, 50d each can be configured to include, without limitation, UPSs. The IT equipment racks 52a, 52b, 52c, 52d, 52e, 52f, 52g, 52h each can be configured to include IT equipment, such as servers, telecommunications and networking equipment and hardware, displays, and related equipment. The generic racks 54a, 54b, 54c, 54d, 54e, 54f each can be configured to include other types of equipment, such as battery modules, cooling modules, and the like.

As shown, the fronts of the power converter cabinets 50a, 50b, 50c, 50d, the IT equipment racks 52a, 52b, 52c, 52d, 52e, 52f, 52g, 52h and the generic racks 54a, 54b, 54c, 54d, 54e, 54f face outwardly, and the backs of the power converter cabinets, the IT equipment racks and the generic racks face inwardly towards one another, with little or no space between the respective pieces of equipment. The arrangement is such that the backs of power converter cabinets 50a, 50b face the backs of power converter cabinets 50c, 50d, respectively, the backs of IT equipment racks 52a, 52b, 52c, 52d face the backs of IT equipment racks 52e, 52f, 52g, 52h, and the backs of generic racks 54a, 54b, 54c face the backs of generic racks 54d, 54e, 54f. As described above with the description of FIG. 2, relatively cool air is directed to the fronts of the power converter cabinets, the IT equipment racks and the generic racks, as shown by arrows 56, drawn through the power converter equipment, the IT equipment and the other equipment, and directed upwardly towards the tops or roofs of the power converter cabinets, the IT equipment racks and the generic racks, as shown by arrows 58. Although not shown, a return plenum or other type of structure can be used to collect and direct return air to a remote location for treatment.

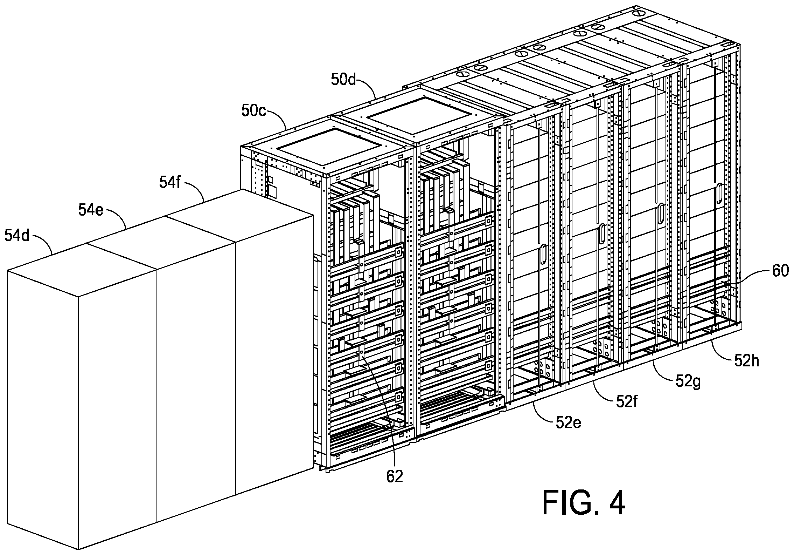

Referring to FIG. 4, two power converter cabinets 50a, 50b, four IT equipment racks 52a, 52b, 52c, 52d, and three generic racks 54a, 54b, 54c are removed to reveal the backs of power converter cabinets 50c, 50d, IT equipment racks 52e, 52f, 52g, 52h, and generic racks 54d, 54e, 54f. Thus, the two power converter cabinets 50c, 50d, IT equipment racks 52e, 52f, 52g, 52h, and generic racks 54d, 54e form a single row of equipment racks. As shown, power is distributed through the power converter cabinets 50c, 50d and the IT equipment racks 52e, 52f, 52g, 52h (and optionally through the generic racks 54d, 54e, 54f) by horizontal busbars, together indicated at 60, that pass through and between the rows of cabinets and racks. The result is that the second row of equipment racks is positioned next to the first row of equipment racks so that the equipment racks of both rows of equipment racks can be connected to the horizontal busbars 60 extending horizontally through the equipment racks.

In one embodiment, the power converters of the power converter cabinets 50c, 50d are directly connected to the busbars 60 and power supply units of the IT equipment racks 52e, 52f, 52g, 52h are directly connected to the busbars. In the power converter cabinets, vertical busbars, each indicated at 62, are provided to provide power to the power converters stacked within the power converter cabinets 50c, 50d. In the IT equipment racks, the power supply units, which are optional, are configured to provide power to the modules, e.g., servers, within the IT equipment racks 52e, 52f, 52g, 52h. The power supply units are provided to reduce voltage required for the electronic equipment housed within the IT equipment racks.

As noted, the horizontal busbars 60 are configured to provide power to the electronic equipment supported by the equipment racks of the first row of equipment racks and to provide power to electronic equipment supported by the equipment racks of the second row of equipment racks. The vertical busbars 62 are configured to provide power to the electronic equipment supported by adjacently placed particular equipment racks. The size (cross-sectional area) and material of each busbar 60, 62 can be selected based on the amount of current to be delivered to the electronic equipment supported by the power converter cabinets, the IT equipment racks and optionally the generic racks. Further, the busbars 60, 62 are each suitably supported by the power converter cabinets, the IT equipment racks and optionally the generic racks in such a manner that the busbars 60, 62 are electrically isolated from the power converter cabinets, the IT equipment racks and optionally the generic racks.

As will be described below, power converter cabinets 50a, 50b similarly can be configured to include horizontal busbars and vertical busbars to deliver power to power converters supported by the power converter cabinets, and IT equipment racks 52a, 52b, 52c, 52d similarly can be configured to include horizontal busbars to deliver power to modules supported by the IT equipment racks.

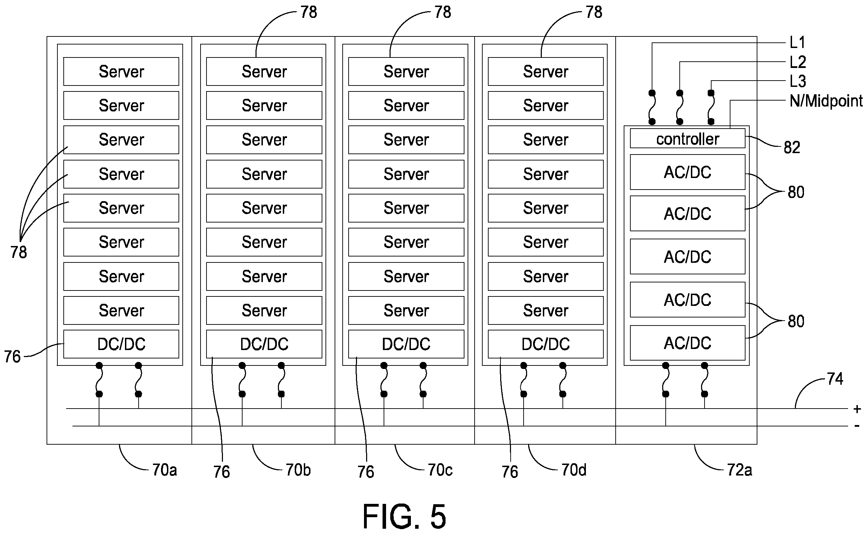

In one example, with reference to FIG. 5, a single row of equipment racks consists of four IT equipment racks 70a, 70b, 70c, 70d and a single power converter cabinet 72a. As shown, the busbars, together indicated at 74, are connected to power supply units, each indicated at 76, of the IT equipment racks 70a, 70b, 70c, 70d (designated DC/DC in FIG. 5). The busbar 74 further may be connected to power supply units of IT equipment racks of a second row of equipment racks adjacent to the single row of equipment racks. The power supply units 76 are configured to provide power to servers, each indicated at 78. The busbars 74 further are connected to the power converters, each indicated at 80, provided in the power converter cabinet 72a (designated AC/DC in FIG. 5). A controller 82 is provided to control the operation of the power supply units 76 of the power converter cabinet 72a. The controller 82 can be configured to control the operation of other components of the row of equipment racks. The shown embodiment illustrates a row rectifier feeding low voltage direct current (LVDC) via integrated busbars. Other voltage and protection schemes may be used.

It should be understood that each row of equipment racks can be configured to include a horizontal busbar and vertical busbars to power electronic equipment contained in the equipment racks.

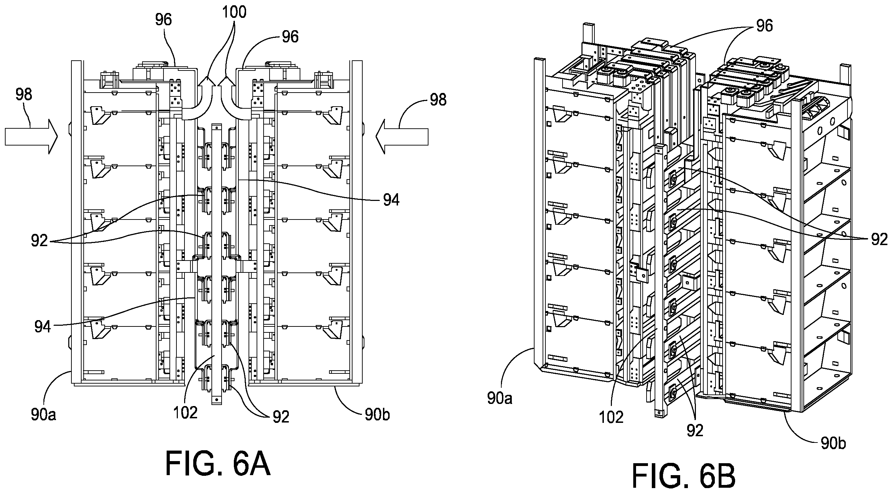

Referring to FIGS. 6A and 6B, in one embodiment, two power converter cabinets 90a, 90b are positioned with the backs of the power converter cabinets facing and proximate to one another. As shown, busbars, each indicated at 92, extend horizontally between the power converter cabinets 90a, 90b to power equipment (power converters) stacked within the power converter cabinets. The horizontal busbars 92 extend in a direction along a length of a row of power converter cabinets and IT equipment racks. Vertical busbars, each indicated at 94, are provided, with L-shaped busbars, each indicated at 96, provided at the tops of the power converter cabinets 90a, 90b. As shown, air from a cold aisle enters the fronts of the power converter cabinets 90a, 90b, as shown by arrows 98, travels through the power equipment contained within the power converter cabinets, and is exhausted through the tops of the power converter cabinets, as shown by arrows 100. An insulator 102 can be provided between the busbars 92 to electrically isolate the busbars 92 from one another.

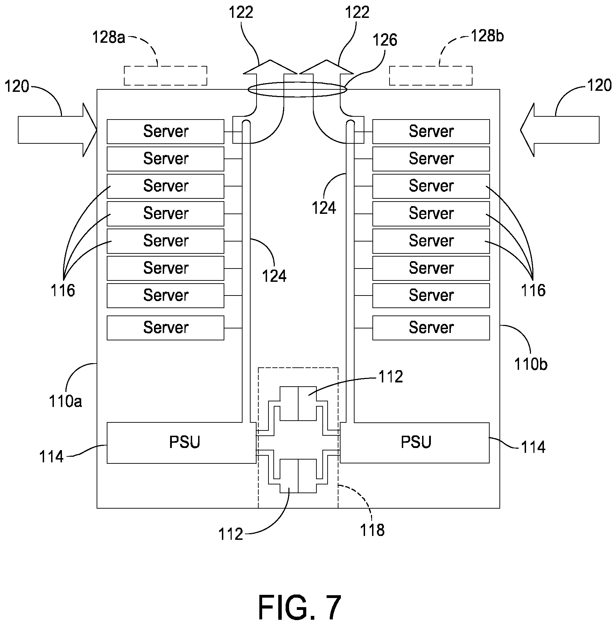

Referring to FIG. 7, in one embodiment, two IT equipment racks 1 10a, 110b are positioned with the backs of the IT equipment racks facing and proximate one another. As shown, a horizontal busbar 112 extends horizontally between the IT equipment racks 110a, 110b adjacent to PSUs, each indicated at 114, which are provided in the IT equipment racks. Power is distributed to servers, each indicated at 116, which are provided in the IT equipment racks 110a, 110b from the PSUs 114, with the PSUs being directly connected to the busbar 112. AC or DC voltage architectures are possible. Further a partition 118 may be provided to compartmentalize or isolate voltage from the busbar 112. The PSUs 114 reduce voltage before being distributed to the electronic equipment provided in the IT equipment racks 110a, 110b, e.g., servers 116. As shown, air enters the fronts of the IT equipment racks, as shown by arrows 120, travels through the electronic equipment, e.g., the servers 116 supported by the IT equipment racks 110a, 110b, and is exhausted through the tops of the IT equipment racks, as shown by arrows 122.

In some embodiments, the servers 116 of the IT equipment racks 1 10a, 110b are cooled by a liquid cooling system 124. As shown, each server 116 is connected to the liquid cooling system 124 to provide liquid cooling to the server.

In some embodiments, an exhaust fan 126 may be provided to exhaust air out of the equipment racks. In one embodiment, the exhaust fan 126 may be provided between the equipment rack 110a of the first row of equipment racks and the equipment rack 110b of the second row of equipment racks. The exhaust fan 126 may be configured to draw or otherwise move air from a front of the equipment rack 110a of the first row of equipment racks and a front of the equipment rack 110b of the second row of equipment racks. The exhaust fan 126 further may be configured to exhaust or otherwise move air through a top of the equipment rack 110a of the first row of equipment racks and through a top of the equipment rack 110b of the second row of equipment racks. The exhaust fan 126 embody a fan module having a fan, with the fan module being coupled to a controller, e.g., controller 82, configured to control the operation of the fan module. In this embodiment, air is configured to be exhausted or removed from the equipment rack 110a of the first row of equipment racks and the equipment rack 110b of the second row of equipment racks and delivered to a return plenum positioned above the equipment racks 110a, 110b.

In some embodiments, there may be several exhaust fans 126 provided along the lengths of the first and second rows of equipment racks, which are spaced from one another.

In another embodiment, an exhaust fan 128a may be provided at top of the equipment rack 110a of the first row of equipment racks and an exhaust fan 128b may be provided at a top of the equipment rack 110b of the second row of equipment racks. Exhaust fan 128a may be configured to draw or otherwise move air from a front of the equipment rack 110a of the first row of equipment racks and to exhaust or otherwise move air through the top of the equipment rack 110a of the first row of equipment racks. Similarly, exhaust fan 128b may be configured to draw or otherwise move air from a front of the equipment rack 110b of the second row of equipment racks and to exhaust or otherwise move air through the top of the equipment rack 110b of the second row of equipment racks. Each exhaust fan 128a, 128b may be coupled to a controller configured to control the operation of each fan module. In this embodiment, air is configured to be exhausted or removed from each equipment rack 110a, 110b and delivered to one or more plenums positioned above the equipment racks 110a, 110b.

In some embodiments, server-based fans can be provided to push/pull air horizontally through the servers in each equipment rack and to exhaust air through the center/top of the equipment rack.

Various controllers may execute various operations discussed above. For example, as discussed above, the controller, such as controller 82, may control the power modules of the power converter cabinet. Using data stored in associated memory and/or storage, the controller may execute one or more instructions stored on one or more non-transitory computer-readable media, which the controller may include and/or be coupled to, that may result in manipulated data. In some examples, the controller may include one or more processors or other types of controllers. In one example, the controller is or includes at least one processor. In another example, the controller performs at least a portion of the operations discussed above using an application-specific integrated circuit tailored to perform particular operations in addition to, or in lieu of, a general-purpose processor. As illustrated by these examples, examples in accordance with the present disclosure may perform the operations described herein using many specific combinations of hardware and software and the disclosure is not limited to any particular combination of hardware and software components. Examples of the disclosure may include a computer-program product configured to execute methods, processes, and/or operations discussed above. The computer-program product may be, or include, one or more controllers and/or processors configured to execute instructions to perform methods, processes, and/or operations discussed above.

It should be understood that embodiments of the present disclosure offer a high-density IT row with front-to-top airflow allowing power conversion and IT equipment to be racked/installed from both sides, and combining two legacy rows into a single row. Further, integrated horizontal busbars are provided between power conversion racks and IT enclosure with power converters and IT PSUs directly connected the horizontal through-bus (from both sides).

In some embodiments, the airflow and power arrangements are independent of each other.

In some embodiments, the arrangement increases the power density of IT rows by eliminating the hot aisle. Further, the arrangement simplifies high-power distribution by eliminating cabling, connectors and separate overhead busway.

In some embodiments, an optional arrangement may include a row rectifier feeding LVDC within a row via integrated busbars. Voltage and protection are options, but many other voltages and protection schemes may be used.

In some embodiments, liquid cooling may be provided using horizontal pipes.

Further examples are provided in the following clauses.
Clause 1. An equipment rack arrangement, comprising:
   a first row of equipment racks; and
   at least one horizontal busbar extending horizontally through the equipment racks of the first row of equipment racks, the at least one horizontal busbar being configured to provide power to electronic equipment supported by the equipment racks of the first row of equipment racks.
Clause 2. The equipment rack arrangement of clause 1, further comprising at least one vertical busbar extending vertically through equipment racks of the first row of equipment racks.
Clause 3. The equipment rack arrangement of clause 1, wherein the first row of equipment racks includes at least one first power converter cabinet and at least two first IT equipment racks.
Clause 4. The equipment rack arrangement of clause 3, wherein the first row of equipment racks further includes at least one generic rack.
Clause 5. The equipment rack arrangement of clause 1, further comprising a second row of equipment racks positioned next to the first row of equipment racks, the at least one horizontal busbar extending horizontally through the equipment racks of the second row of equipment racks, the at least one horizontal busbar being configured to provide power to electronic equipment supported by the equipment racks of the second row of equipment racks.
Clause 6. The equipment rack arrangement of clause 5, wherein relatively cold air is configured to enter fronts of equipment racks of the first row of equipment racks and fronts of equipment racks of the second row of equipment racks and relatively hot air is configured to exit tops of equipment racks of the first row of equipment racks and tops of equipment racks of the second row of equipment racks.
Clause 7. The equipment rack arrangement of clause 5, further comprising an airflow divider positioned between the first row of equipment racks and the second row of equipment racks.
Clause 8. The equipment rack arrangement of clause 5, further comprising at least one fan configured to move the relatively cold air through fronts of the equipment racks of the first row of equipment racks and through fronts of the equipment racks of the second row of equipment racks and to move relatively hot air through tops of the equipment racks of the first row of equipment racks and through tops of the equipment racks of the second row of equipment racks.
Clause 9. The equipment rack arrangement of clause 5, further comprising at least one vertical busbar extending vertically through equipment racks of the first row of equipment racks and equipment racks of the second row of equipment racks.
Clause 10. The equipment rack arrangement of clause 5, wherein the first row of equipment racks includes at least one first power converter cabinet and at least two first IT equipment racks and the second row of equipment racks includes at least one second power converter cabinet and at least two second IT equipment racks, and
   wherein the at least one first power converter cabinet is positioned adjacent to the at least one second power converter cabinet, and the at least two first IT equipment racks are positioned adjacent to the at least two second IT equipment racks, the at least one horizontal busbar extending between the at least one first power converter cabinet and the at least one second power converter cabinet and between the at least two first IT equipment racks and the at least two second IT equipment racks.
Clause 11. The equipment rack arrangement of clause 1, further comprising at least one fan configured to move the relatively cold air through fronts of the equipment racks of the first row of equipment racks and to move relatively hot air through tops of the equipment racks of the first row of equipment racks.
Clause 12. The equipment rack arrangement of clause 1, further comprising a liquid cooling system configured to provide liquid cooling to the electronic equipment supported by the equipment racks of the first row of equipment racks.
Clause 13. The equipment rack arrangement of clause 1, further comprising a partition to electrically isolate the at least one horizontal busbar.
Clause 14. A method of installing equipment racks, comprising:
   installing a first row of equipment racks; and
   installing at least one horizontal busbar to extend horizontally through the equipment racks of the first row of equipment racks, the at least one horizontal busbar being configured to provide power to electronic equipment supported by the equipment racks of the first row of equipment racks.
Clause 15. The method of clause 14, further comprising installing at least one vertical busbar through equipment racks of the first row of equipment racks.
Clause 16. The method of clause 14, wherein the first row of equipment racks includes at least one first power converter cabinet and at least two first IT equipment racks.
Clause 17. The method of clause 16, wherein the first row of equipment racks further includes at least one generic rack.
Clause 18. The method of clause 14, further comprising installing a second row of equipment racks next to the first row of equipment racks, the at least one horizontal busbar extending horizontally through the equipment racks of the second row of equipment racks, the at least one horizontal busbar being configured to provide power to electronic equipment supported by the equipment racks of the second row of equipment racks.
Clause 19. The method of clause 18, further comprising moving relatively cold air through fronts of equipment racks of the first row of equipment racks and through fronts of equipment racks of the second row of equipment racks, and moving relatively hot air through tops of equipment racks of the first row of equipment racks and tops of equipment racks of the second row of equipment racks.
Clause 20. The method of clause 19, wherein moving relatively cold air and moving relatively hot air is achieved by at least one fan.
Clause 21. The method of clause 18, further comprising installing at least one vertical busbar through equipment racks of the first row of equipment racks and equipment racks of the second row of equipment racks.
Clause 22. The method of clause 18, further comprising installing an airflow divider between the first row of equipment racks and the second row of equipment racks.
Clause 23. The method of clause 14, further comprising moving relatively cold air through fronts of equipment racks of the first row of equipment racks and moving relatively hot air through tops of equipment racks of the first row of equipment racks.
Clause 24. The method of clause 14, further comprising providing liquid cooling to the electronic equipment supported by the equipment racks of the first row of equipment racks.
Clause 25. The method of clause 14, further comprising installing a partition to electrically isolate the at least one busbar.

Having thus described several aspects of at least one embodiment, it is to be appreciated various alterations, modifications, and improvements will readily occur to those skilled in the art. Such alterations, modifications, and improvements are intended to be part of this disclosure and are intended to be within the scope of the disclosure. Accordingly, the foregoing description and drawings are by way of example only.

## Claims

1. An equipment rack arrangement, comprising:
a first row of equipment racks; and
at least one horizontal busbar extending horizontally through the equipment racks of the first row of equipment racks, the at least one horizontal busbar being configured to provide power to electronic equipment supported by the equipment racks of the first row of equipment racks.

2. The equipment rack arrangement of claim 1, further comprising at least one vertical busbar extending vertically through equipment racks of the first row of equipment racks.

3. The equipment rack arrangement of claims 1 or 2, wherein the first row of equipment racks includes at least one first power converter cabinet and at least two first IT equipment racks.

4. The equipment rack arrangement of any of the above claims, further comprising a second row of equipment racks positioned next to the first row of equipment racks, the at least one horizontal busbar extending horizontally through the equipment racks of the second row of equipment racks, the at least one horizontal busbar being configured to provide power to electronic equipment supported by the equipment racks of the second row of equipment racks.

5. The equipment rack arrangement of claim 4, wherein relatively cold air is configured to enter fronts of equipment racks of the first row of equipment racks and fronts of equipment racks of the second row of equipment racks and relatively hot air is configured to exit tops of equipment racks of the first row of equipment racks and tops of equipment racks of the second row of equipment racks or the equipment rack further comprising an airflow divider positioned between the first row of equipment racks and the second row of equipment racks or the equipment rack further comprising at least one fan configured to move the relatively cold air through fronts of the equipment racks of the first row of equipment racks and through fronts of the equipment racks of the second row of equipment racks and to move relatively hot air through tops of the equipment racks of the first row of equipment racks and through tops of the equipment racks of the second row of equipment racks.

6. The equipment rack arrangement of claim 4, wherein the first row of equipment racks includes at least one first power converter cabinet and at least two first IT equipment racks and the second row of equipment racks includes at least one second power converter cabinet and at least two second IT equipment racks, and
wherein the at least one first power converter cabinet is positioned adjacent to the at least one second power converter cabinet, and the at least two first IT equipment racks are positioned adjacent to the at least two second IT equipment racks, the at least one horizontal busbar extending between the at least one first power converter cabinet and the at least one second power converter cabinet and between the at least two first IT equipment racks and the at least two second IT equipment racks.

7. The equipment rack arrangement of any of the above claims, further comprising a liquid cooling system configured to provide liquid cooling to the electronic equipment supported by the equipment racks of the first row of equipment racks.

8. The equipment rack arrangement of any of the above claims, further comprising a partition to electrically isolate the at least one horizontal busbar.

9. A method of installing equipment racks, comprising:
installing a first row of equipment racks; and
installing at least one horizontal busbar to extend horizontally through the equipment racks of the first row of equipment racks, the at least one horizontal busbar being configured to provide power to electronic equipment supported by the equipment racks of the first row of equipment racks.

10. The method of claim 9, further comprising installing at least one vertical busbar through equipment racks of the first row of equipment racks.

11. The method of claim9, further comprising installing a second row of equipment racks next to the first row of equipment racks, the at least one horizontal busbar extending horizontally through the equipment racks of the second row of equipment racks, the at least one horizontal busbar being configured to provide power to electronic equipment supported by the equipment racks of the second row of equipment racks.

12. The method of claim 11, further comprising moving relatively cold air through fronts of equipment racks of the first row of equipment racks and through fronts of equipment racks of the second row of equipment racks, and moving relatively hot air through tops of equipment racks of the first row of equipment racks and tops of equipment racks of the second row of equipment racks.

13. The method of claim 11, further comprising installing an airflow divider between the first row of equipment racks and the second row of equipment racks.

14. The method of claim 9, further comprising providing liquid cooling to the electronic equipment supported by the equipment racks of the first row of equipment racks.

15. The method of claim 9, further comprising installing a partition to electrically isolate the at least one busbar.
